# EUROPEAN PATENT APPLICATION

(11) **EP 3 010 317 A1**
(43) Date of publication of application: **20.04.2016**
(21) Application number: 14188919.6
(22) Date of filing: 15.10.2014
(51) Int. Cl.: H05K 7/14

(54) **Industrial server system**

(71) Applicant: Lanner Electronic Inc., New Taipei City 221 (TW)
(72) Inventor: Lin, Tse Min, 221 New Taipei City (TW)
(74) Representative: Becker Kurig Straus

(57) **Abstract**

The present invention relates to an industrial server system, comprising a housing (11), a backplane (12), at least one rear board (13), at least one front board (14), and a power supply (15), wherein the backplane and the power supply are disposed in the housing, and the rear board, the first front board are coupled and configured to the backplane. Four connected blocks are disposed on the backplane, which makes that at least one rear board and at least one front board are able to communicate to each other by a plurality of data connecting units disposed on the backplane. The rear board and the first front board of the present invention can achieve a great transmission efficiency by a specific configuration of connected block on the backplane.

## Description

### BACKGROUND OF THE INVENTION

### 1. Field of the Invention

The present invention relates to an industrial server system, and more particularly, to an industrial server system compatible with advanced telecom computing architecture.

### 2. Description of the Prior Art

Modular systems are typically used in communication networks where reliability and cost effectiveness are important factors. Such modular systems include one or more backplanes that receive and couple to other interoperable pieces such as circuit boards or "boards". These boards may include, but are not limited to blades, carrier boards, processing boards, interconnects, etc. Other interoperable pieces that a backplane may receive and couple to include components such as fans, power equipment modules (PEM), field replaceable units (FRUs), alarm boards, etc.

Backplanes within a modular platform system may receive and couple boards via one or more data transport and power connectors. Typically, the one or more data transport connectors include communication links to interconnect boards received and coupled to the backplane. These communication links may also couple interconnected boards to components resident on a given board (e.g., mezzanine cards, processing elements, chipsets, media devices, etc.). Data and/or instructions are forwarded on these communication links using various different communication protocols. Typically a data transport interface is used to serve as a bridge between the communication links that use different communication protocols.

The inventor of the present application has made great efforts to make inventive research thereon and eventually provided an industrial server system.

### SUMMARY OF THE INVENTION

The primary objective of the present invention is to dispose four connected blocks on a backplane, such that at least one rear board and at least one front board are able to communicate to each other by a plurality of data connecting units disposed on the backplane. Thus, The rear board, the first front board, and the second front board of the present invention can achieve a great transmission efficiency by a specific configuration of connector on the backplane.

Accordingly, to achieve the primary objective of the present invention, the inventor of the present invention provides an industrial server system, comprising: a housing;
a backplane disposed in the housing comprises:
a first connected block consists of:
   two first transmitting areas disposed on the obverse side of the backplane in a column; and
   a plurality of first data connected areas disposed on the reverse side of the backplane in a column;
a second connected block located beside the first connected block consists of: two second transmitting areas disposed on the obverse side of the backplane in a column and located beside the first data connected areas contrary to the two first transmitting areas;
a primary circulation opening area formed on the backplane and located nearby the second transmitting areas, for circulating the air in front of and behind the backplane;
a plurality of second data connected areas disposed on the reverse side of the backplane in a column; and
a plurality of first power supply areas disposed on the reverse side of the backplane and located nearby the second data connected areas;
a third connected block , located beside the second connected block contrary to the first connected block , consists of:
   two third transmitting areas disposed on the obverse side of the backplane in a column; and
   two second power supply areas disposed on the obverse side of the backplane and located beside the third transmitting areas; and
a fourth connected block, located beside the third connected block contrary to the second connected block;
at least one rear board connected to the reverse side of the backplane has a first data connector, a second data connector, and a first power supply connector, wherein the first data connector, the second data connector, and the first power supply connector are correspondingly connected to the first data connected areas, the second data connected areas, and the first power supply areas;
at least one front board connected to the obverse side of the backplane has a first transmitting connector, a second transmitting connector, a third transmitting connector, and a second power supply connector, wherein the first transmitting connector, the second transmitting connector, the third transmitting connector, and the second power supply connector are correspondingly connected to the first transmitting areas, the second transmitting areas, the third transmitting areas, and the second power supply areas; and
a power supply, disposed in the housing and connected to the fourth connected block.

### BRIEF DESCRIPTION OF THE DRAWINGS

The invention as well as a preferred mode of uses and advantages thereof will be best understood by referring to the following detailed description of an illustrative embodiment in conjunction with the accompanying drawings, wherein:
FIG. 1 is a stereo view of an industrial server system according to the present invention;
FIG. 2 is a stereo view of part of the industrial server system;
FIG. 3 is a schematic view of the obverse side of the backplane;
FIG. 4 is a stereo view of the front board;
FIG. 5 is a schematic view of the reverse side of the backplane; and
FIG. 6 is a stereo view of the rear board.

### DETAILED DESCRIPTION OF THE PREFERRED EMBODIMENTS

To more clearly describe an industrial server system according to the present invention, embodiments of the present invention will be described in detail with reference to the attached drawings hereinafter.

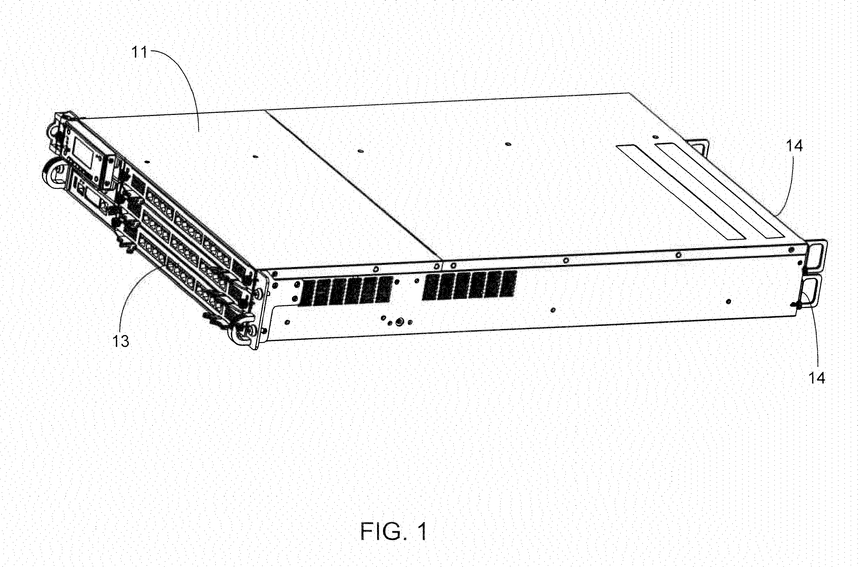

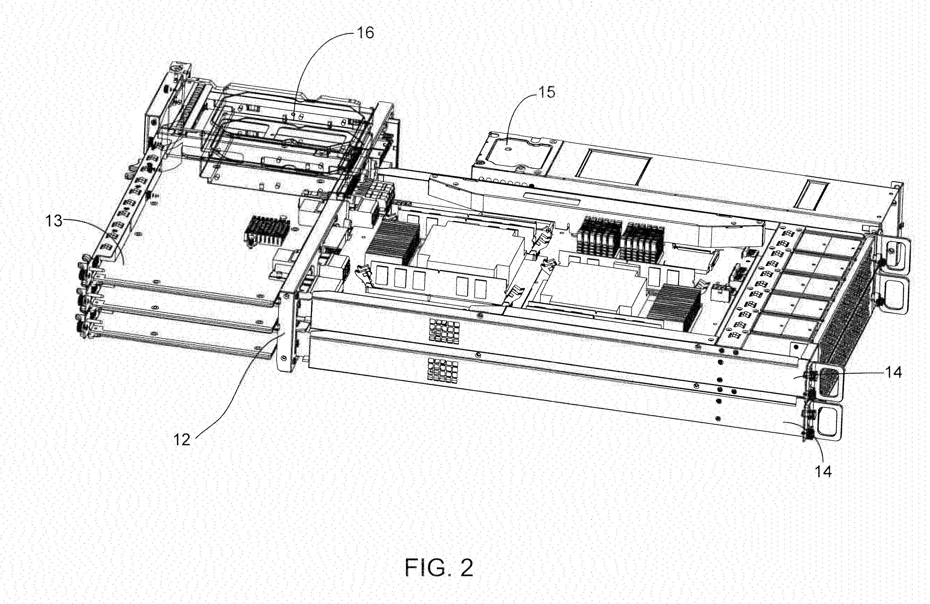

With reference to FIG. 1, which illustrate a stereo view of an industrial server system according to the present invention. Moreover, please simultaneously refer to FIG. 2, there is shown a stereo view of part of the industrial server system. As shown in FIG. 1 and FIG. 2, the industrial server system 1 comprises a housing 11, a backplane 12, at least one rear board 13, at least one front board 14, and a power supply 15, wherein the backplane 12 and the power supply 15 are disposed on the housing 11. The rear board 13, the front board 14, and the second front board 15 are coupled and configured to the backplane 12.

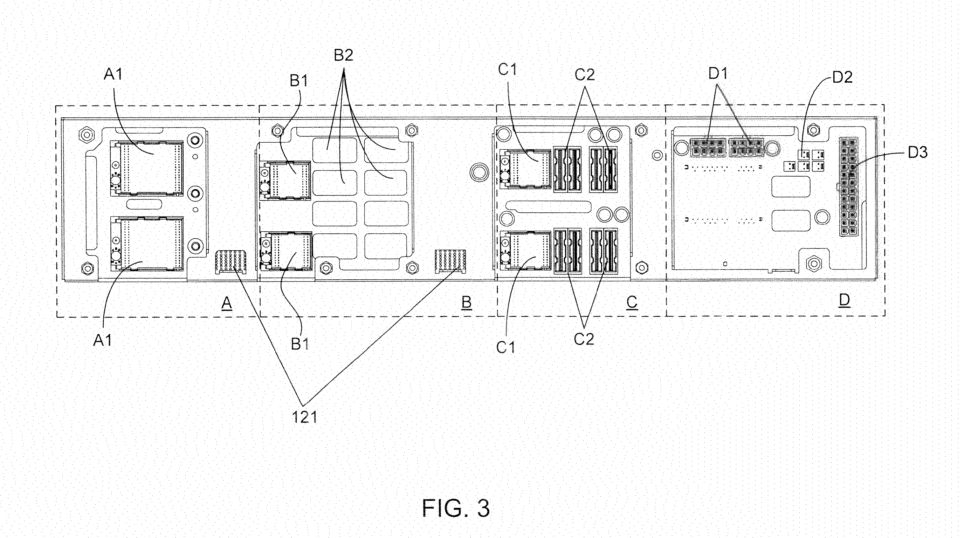

Please refer to FIG. 3, which illustrates a schematic view of the obverse side of the backplane. As FIG. 3 shows, the backplane 12 comprises a first connected block A, a second connected block B, a third connected block C, and a fourth connected block D, wherein the second connected block B locates beside the first connected block A, the third connected block C locates beside the second connected block B contrary to the first connected block A, and the fourth connected block D locates beside the third connected block C contrary to the second connected block B.

Inheriting to above descriptions, the configuration of the obverse side of the backplane 12 will be fully described by following statements. The first connected block A comprises two first transmitting areas A1 disposed on the obverse side of the backplane 12 in a column. The second connected block B located on the right side of the first connected block A consists of two second transmitting areas B1 disposed on the obverse side of the backplane 12 in a column, and a primary circulation opening area B2 formed on the backplane 12 and located on the right side of the second transmitting areas B1 for circulating the air in front of and behind the backplane 12.

The third connected block C located on the right side of the second connected block B consists of two third transmitting areas C1 disposed on the obverse side of the backplane in a column, and two second power supply areas C2 disposed on the obverse side of the backplane and located beside the third transmitting areas C1. The fourth connected block D located on the right side of the third connected block C consists of a first power supply area D1 disposed on the upper half of the fourth connected block D for receiving electricity provided by the power supply 15, a control module area D2 disposed on the right side of the first power supply area D1 for monitoring the industrial server system 1, and a second power supply area D3 disposed on the right side of the control module area D2 for receiving electricity provided by the power supply 15. The control module area D2 is a control transmitting interface to the power supply 15 for status displaying, hardware/software resetting, and power switching.

Thus, through above descriptions, the configuration of the obverse side of the backplane 12 has been introduced completely and clearly. Herein, it needs to further explain that the backplane 12 further comprises at least one secondary circulation opening area formed on unused area of the backplane 12 for better cooling effect. Besides, the backplane 12 is fixed in the housing 11 by at least one fixer 121 disposed on the obverse side of the backplane 12.

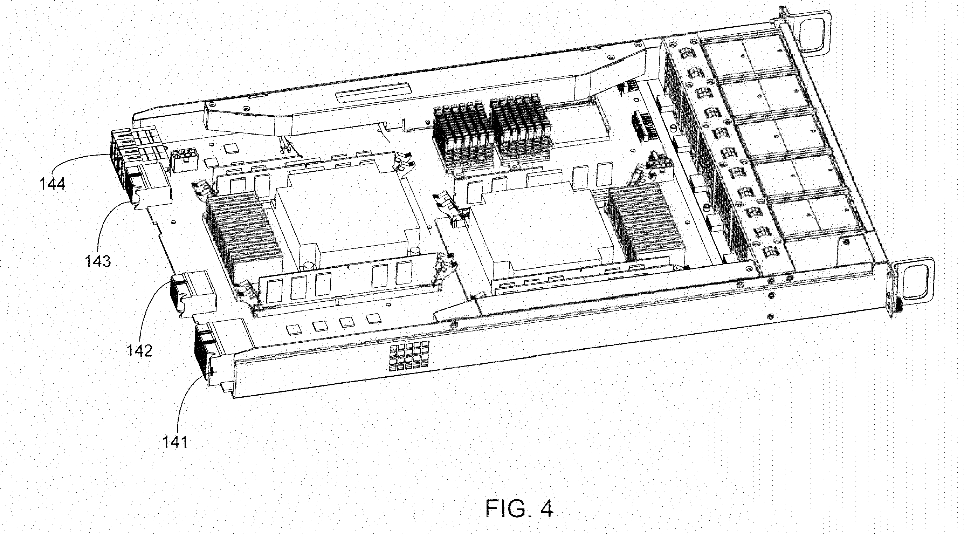

Referring to FIG. 3 again, and please simultaneously refer to FIG. 4, which illustrate a stereo view of the front board. As FIG. 4 shows, the front board 14 connected to the obverse side of the backplane 12 has a first transmitting connector 141, a second transmitting connector 142, a third transmitting connector 143, and a second power supply connector 144, wherein the first transmitting connector 141, the second transmitting connector 142, the third transmitting connector 143, and the second power supply connector 144 are correspondingly connected to the first transmitting area A1, the first power supply areas B4, fifth transmitting area C1, and the second power supply area C3.

The front board 14 comprises an intelligent platform management controller (IPMC) for monitoring and recording processes of the front board 14, as well as reporting and dealing with abnormal events; moreover, the IPMC is also used for managing a power switch and at least one data channel switch of the front board 14, wherein the front board 14 further comprises a complex instruction set computer (CISC).

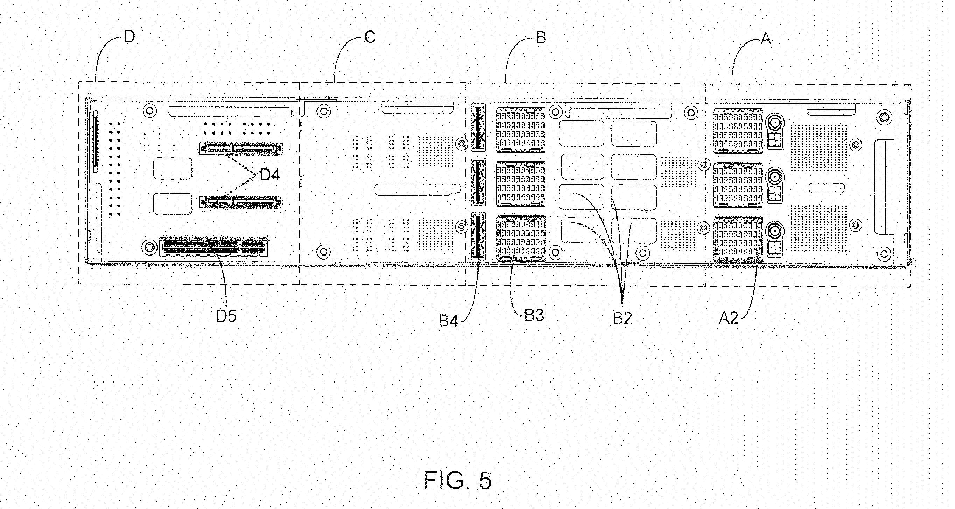

Inheriting to above descriptions, the configuration of the reverse side of the backplane 12 will be fully described by following statements. Please refer to FIG. 5, which illustrates a schematic view of the reverse side of the backplane. As FIG. 5 shows, the first connected block A includes three first data connected areas A2 disposed on the reverse side of the backplane 12 in a column, wherein the first data connected areas A2 is located beside the second connected block B. The second connected block B includes three second data connected areas B3 disposed on the reverse side of the backplane 12 in a column, and three first power supply areas B4 disposed in a column on the left side of the second data connected areas B3, wherein the first power supply areas B4 are located beside the third connected block C. The second connected block D includes a data storage device slot area D4 located beside the third connected block C and a input/output area D5 located beneath the data storage device slot area D4 for coupling at least one electric module, wherein the data storage device slot area D4 has two hard disc drive slot for coupling at least one hard disc drive. Besides, the aforesaid electric module is selected from the group consisting of: universal serial bus, local area network, wireless local area network, integrated drive electronics, audio device, advanced technology attachment, audio device and other input/output device. Referring FIG. 3 again, the third transmitting area C1 is a transmitting interface to the front board 14, the control module area D2, the data storage device slot area D4, and the input/output area D5.

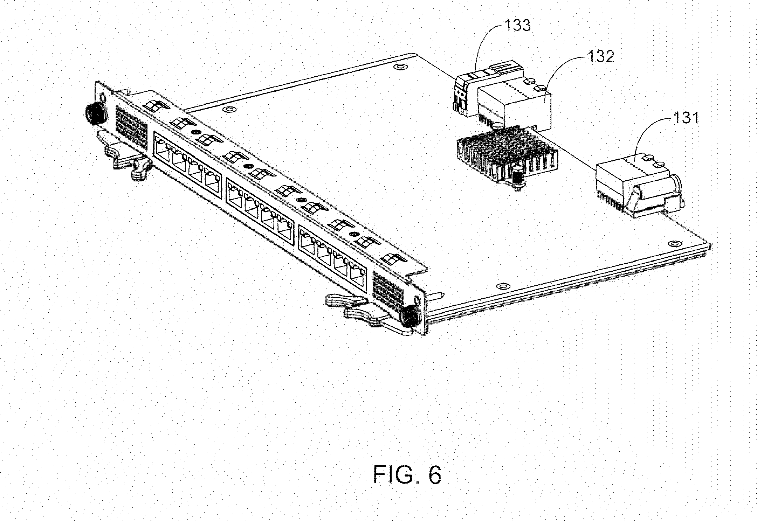

Please refer to FIG. 5 and simultaneously refer to FIG. 6, there is shown a stereo view of the rear board. As shown in FIG. 6, at least one rear board 13 connected to the reverse side of the backplane 12 has a first data connector 131, a second data connector 132, and a first power supply connector 133, wherein the first data connector 131, the second data connector 132, and the first power supply connector 133 are correspondingly connected to the first data connected areas A2, the second data connected areas B3, and the first power supply areas B4. The rear board 13 is an advanced mezzanine card comprising a communication channel, a module management controller, a module controlling logic, a module memory, an input/output interface, a module interface, a hot-swap electronics, and an extended application unit, wherein said module memory is selected from the group consisting of: volatile memory, non-volatile memory, flash memory, random access memory, and read-only memory; and said module controlling logic is selected from the group consisting of: microprocessor, network processor, micro controller unit, field programmable gate array, and application specific integrated circuit.

Inheriting to above descriptions, in a prefer embodiment of present invention, the industrial server system 1 is disposing three rear boards 13 and a front board 14, on a backplane 12. Regarding the front board 14 as a primary input, wherein the front board 14 transmits data signals to the backplane 12 through the first transmitting areas A1 and the second transmitting areas B1. The first transmitting areas A1 includes two PCIe x8 (Peripheral Component Interconnect Express), and two PCIe x4. The second transmitting area B1 includes two PCIe x8. On the other hand, each rear board 13 receives the data signals transmitted from the front board 14 through a XAUI and a PCIe x8 of each first data connected area A2. Moreover, each rear board 13 also receives the data signals transmitted from the front board 14 through three XAUI of each second data connected area B3.

Herein, it needs to further explain that the present invention disposes two front board 14 comprising CISC on the backplane 12 simultaneously, such that the industrial server system 1 can execute and process numerous compressed packet data faster and more efficient.

Thus, through the foregoing descriptions, the industrial server system has been completely introduced and disclosed; in summary, the present invention has the following advantages:
1. In the present invention, a backplane 12 is dispose four connected blocks(A, B, C, D), such that at least one rear board and at least one front board are able to communicate to each other by a plurality of data connecting units disposed on the backplane. Particularly, the third connected block C in the present invention is located beside the fourth connected block D, which makes the second power supply area C3 and the third power supply area C4 close to the first power supply area D1 and the second power supply area D3. Thus, the present invention can achieve a great transmission efficiency by aforesaid specific configuration of connected block on the backplane.
2. Inheriting to above point 1, the third transmitting area C1, a primary I/O interface, is disposed on the third connected block C for disposing close to the input/output area D5 and increasing transmission efficiency.
3. Moreover, the backplane 12 of the present invention comprises many circulation opening areas for better cooling effect. For example, the primary circulation opening area B2 is disposed between the second transmitting area B1 and the second data connected areas B3 for corresponding to principle circuits and electronic components of the front board 14.

The above description is made on embodiments of the present invention. However, the embodiments are not intended to limit scope of the present invention, and all equivalent implementations or alterations within the spirit of the present invention still fall within the scope of the present invention.

## Claims

1. An industrial server system, comprising:
a housing ;
a backplane disposed in the housing comprises:
a first connected block consists of:
two first transmitting areas disposed on the obverse side of the backplane in a column; and
a plurality of first data connected areas disposed on the reverse side of the backplane in a column;
a second connected block located beside the first connected block consists of: two second transmitting areas disposed on the obverse side of the backplane in a column and located beside the first data connected areas contrary to the two first transmitting areas;
a primary circulation opening area formed on the backplane and located nearby the second transmitting areas, for circulating the air in front of and behind the backplane;
a plurality of second data connected areas disposed on the reverse side of the backplane in a column; and
a plurality of first power supply areas disposed on the reverse side of the backplane and located nearby the second data connected areas;
a third connected block , located beside the second connected block contrary to the first connected block , consists of:
two third transmitting areas disposed on the obverse side of the backplane in a column; and
two second power supply areas disposed on the obverse side of the backplane and located beside the third transmitting areas;
a fourth connected block, located beside the third connected block contrary to the second connected block;
at least one rear board connected to the reverse side of the backplane has a first data connector, a second data connector, and a first power supply connector, wherein the first data connector, the second data connector, and the first power supply connector are correspondingly connected to the first data connected areas, the second data connected areas, and the first power supply areas;
at least one front board connected to the obverse side of the backplane has a first transmitting connector, a second transmitting connector, a third transmitting connector, and a second power supply connector, wherein the first transmitting connector, the second transmitting connector, the third transmitting connector, and the second power supply connector are correspondingly connected to the first transmitting areas, the second transmitting areas, the third transmitting areas, and the second power supply areas; and
a power supply, disposed in the housing and connected to the fourth connected block.

2. The industrial server system as recited in claim 1, wherein the fourth connected block comprises:
a first power supply area, disposed on the obverse side of the backplane for receiving electricity provided by the power supply;
a control module area, disposed on the obverse side of the backplane and beside the first power supply area for monitoring the industrial server system;
a second power supply area, disposed on the obverse side of the backplane and beside the control module area for receiving electricity provided by the power supply;
a data storage device slot area, disposed on the reverse side of the backplane for coupling at least one data storage device; and
an input/output area, disposed on the reverse side of the backplane and located beneath the data storage device slot area for coupling at least one electric module.

3. The industrial server system as recited in claim 2, wherein the electric module is selected from the group consisting of: universal serial bus, local area network, wireless local area network, integrated drive electronics, audio device, advanced technology attachment, audio device and other input/output device.

4. The industrial server system as recited in claim 2, wherein the control module area is a control transmitting interface to the power supply for status displaying, hardware/software resetting, and power switching.

5. The industrial server system as recited in claim 1, wherein the rear board is an advanced mezzanine card comprising a communication channel, a module management controller, a module controlling logic, a module memory, an input/output interface, a module interface, a hot-swap electronics, and an extended application unit.

6. The industrial server system as recited in claim 5, wherein the module memory is selected from the group consisting of: volatile memory, non-volatile memory, flash memory, random access memory, and read-only memory.

7. The industrial server system as recited in claim 5, wherein the module controlling logic is selected from the group consisting of: microprocessor, network processor, micro controller unit, field programmable gate array, and application specific integrated circuit.

8. The industrial server system as recited in claim 1, wherein the first transmitting areas A1 includes two PCIe x8 (Peripheral Component Interconnect Express), and two PCIe x4.

9. The industrial server system as recited in claim 1, wherein the first connected block comprises three first data connected areas A2, and each first data connected area A2 includes a XAUI and a PCIe x8.

10. The industrial server system as recited in claim 1, wherein the second transmitting area includes two PCIe x8.

11. The industrial server system as recited in claim 1, wherein the second connected block comprises three second data connected areas B3, and each second data connected area B3 includes three XAUI.

12. The industrial server system as recited in claim 2, wherein the third transmitting area C1 is a transmitting interface for the front board 14 to the control module area, the data storage device slot area, and the input/output area.

13. The industrial server system as recited in claim 1 comprises at least one secondary circulation opening area formed on unused area of the backplane.

14. The industrial server system as recited in claim 1, wherein the backplane is fixed in the housing by at least one fixer disposed on the obverse side of the backplane.

15. The industrial server system as recited in claim 1, wherein the first front board and the second front board both comprise an intelligent platform management controller (IPMC) for monitoring and recording process of the first front board and the second front board, as well as reporting and dealing with abnormal events; moreover, the IPMC is also used for managing a power switch and at least one data channel switch of the first front board and the second front board.

16. The industrial server system as recited in claim 15, wherein the front board further comprises a complex instruction set computer (CISC).
